# FASCICULE DE BREVET EUROPEEN

(11) **EP 0 944 216 B1**
(45) Date de publication et mention de la délivrance du brevet: **22.01.2003**
(21) Numéro de dépôt: 99410019.6
(22) Date de dépôt: 19.03.1999
(51) Int. Cl.: H04L 27/38, H04L 27/233

(54) **Filtre numérique pour boucle à verrouillage de phase de correction de rotation d'un démodulateur QPSK ou QAM**
Digitales Filter für einen Phasenregelkreis zur Rotationskorrigierung eines QAM oder QPSK-Demodulator
Digital filter for a phase lock loop used for the correction of rotation of a QPSK or QAM demodulator

(30) Priorité: 19.03.1998 FR 9803627
(43) Date de publication de la demande: 22.09.1999
(73) Titulaire: STMicroelectronics S.A., 92120 Montrouge (FR)
(72) Inventeur: Meyer, Jacques, 38950 Saint Martin le Vinoux (FR)
(74) Mandataire: de Beaumont, Michel

(56) Documents cités:
- EP-A- 0 527 249
- US-A- 5 471 508
- US-A- 5 727 027

## Description

La présente invention concerne notamment les techniques de démodulation dites QPSK ("Quadrature Phase-Shift Keying") et QAM ("Quadrature Amplitude Modulation") permettant de transmettre simultanément deux signaux binaires sur deux porteuses de même fréquence mais en quadrature de phase. La présente invention vise plus particulièrement un filtre de boucle de correction de rotation dans un démodulateur numérique.

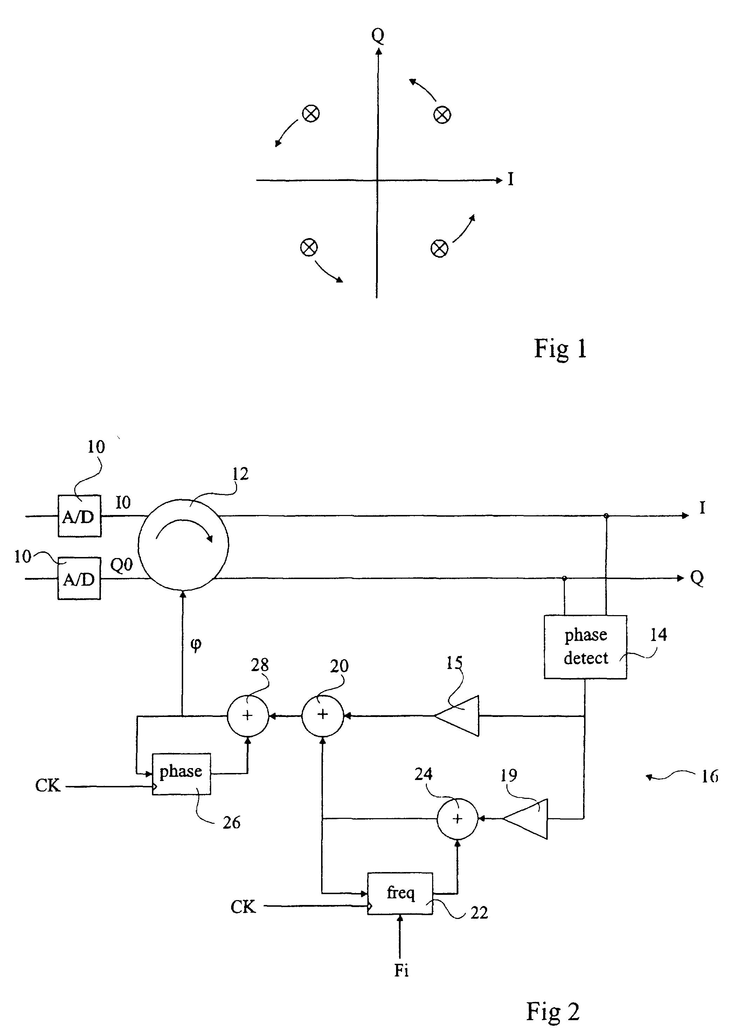

La figure 1 représente sous forme de "constellation" les valeurs possibles de deux signaux binaires I et Q à transmettre. Les valeurs du signal I sont reportées selon un axe horizontal I et les valeurs du signal Q sont reportées selon un axe vertical Q. En modulation QPSK, chacun des signaux binaires I et Q prend une valeur positive ou une valeur négative de même amplitude, correspondant aux niveaux logiques haut et bas. Dans la figure 1, des points représentent les quatre combinaisons possibles des signaux I et Q. Ces points sont normalement symétriques par rapport aux axes I et Q.

La figure 2 représente schématiquement un démodulateur QPSK numérique classique. Le signal modulé subit d'abord une démodulation analogique grossière. Les deux composantes obtenues sont filtrées puis fournies à des convertisseurs analogique-numérique 10. Ainsi, les convertisseurs 10 fournissent respectivement des signaux I0 et Q0 numériques correspondant aux signaux I et Q grossièrement démodulés. Comme cela est indiqué par des flèches en figure 1, la constellation correspondant aux signaux I0 et Q0 tourne par rapport à la constellation nominale à une vitesse égale à l'erreur de fréquence de la démodulation grossière.

Une telle boucle à verrouillage de phase est divulgée dans le document EP0527249.

Ainsi, pour obtenir les signaux I et Q, il faut faire subir à la constellation une rotation en sens inverse à la même vitesse. C'est le rôle d'un circuit de correction de rotation 12 monté dans une boucle à verrouillage de phase. Le circuit de correction de rotation 12 agit en fonction d'un signal de correction ϕ fourni par un détecteur de phase 14 qui analyse les sorties I et Q du circuit 12. La sortie du détecteur de phase 14 est d'abord filtrée par un filtre passe-bas numérique 16. Le détecteur de phase 14 fournit habituellement la différence entre les signaux I et Q, plus spécifiquement la valeur Isgn(Q)-Qsgn(I), où sgn(.) est la fonction "signe de".

Le filtre 16 est généralement un filtre du deuxième ordre qui comprend deux amplificateurs (multiplieurs par une constante) 18 et 19 recevant chacun la sortie du détecteur de phase 14. Un additionneur 20 reçoit la sortie de l'amplificateur 18 et l'intégrale de la sortie de l'amplificateur 19. L'intégrale est obtenue par un intégrateur numérique sous la forme d'un registre 22 connecté à un additionneur 24 pour accumuler les valeurs fournies par l'amplificateur 19.

Le signal ϕ qui commande le circuit de correction de rotation 12 est fourni par un intégrateur sous la forme d'un registre 26 connecté à un additionneur 28 pour accumuler les valeurs fournies par l'additionneur 20.

Les registres 22 et 26 sont cadencés par une horloge CK. L'horloge CK est réglée à la fréquence symbole, c'est-à-dire à la vitesse de transmission des bits par chacun des signaux I et Q.

Avec cette configuration, pour chaque nouveau bit transmis sur les signaux I et Q, les registres 22 et 26 accumulent une nouvelle valeur. En fait, le registre 22 accumule des valeurs de fréquence tandis que le registre 26 accumule des valeurs de phase. En régime établi, le contenu du registre 22 ne varie pas et indique l'erreur de fréquence de la démodulation grossière, tandis que le contenu du registre 26 varie continûment et représente la correction de phase à apporter à la constellation pour la ramener à sa position nominale (figure 1).

Afin de réduire la sensibilité au bruit du démodulateur, la fréquence de coupure du filtre 16 est choisie particulièrement basse, ce qui réduit la plage de capture et augmente la durée de convergence de la boucle à verrouillage de phase. L'incertitude sur la fréquence de porteuse des signaux I et Q est généralement supérieure à la plage de capture, d'où il résulte qu'il faut procéder par essais successifs en initialisant le registre 22 à des valeurs différentes pour trouver une plage de capture adaptée à la fréquence de porteuse effective.

Etant donné que la plage de capture diminue avec la fréquence symbole, le nombre d'essais que l'on doit effectuer, c'est-à-dire le nombre de valeurs de fréquence que l'on doit charger dans le registre 22, augmente corrélativement. Par ailleurs, pour chaque fréquence essayée, il faut traiter un nombre minimal de symboles avant de pouvoir déterminer si la boucle se verrouille ou non, mais la cadence des symboles diminue bien entendu avec la fréquence symbole. Il en résulte que le temps de verrouillage, c'est-à-dire le temps nécessaire à trouver une plage de capture adaptée à la fréquence de porteuse, augmente en moyenne avec le carré de l'inverse de la fréquence symbole.

En prenant comme exemple la réception des signaux transmis par satellite, la fréquence de porteuse varie de ±5 MHz, la fréquence symbole peut être fixée entre 1 et 45 Mbits/s, et la plage de capture est de l'ordre de 0,1 % de la fréquence symbole. Bien que la fréquence de porteuse ait une incertitude de ±5 MHz, il existe des moyens permettant de réduire la plage d'incertitude à une centaine de KHz. Malgré cela, pour une fréquence symbole minimale de 1 MHz, et donc une plage de capture d'environ 1 KHz, il faut effectuer une centaine d'essais de fréquence, chaque essai devant être effectué pendant quelques milliers de symboles. Il en résulte que les temps de verrouillage peuvent atteindre la seconde.

Un objet de la présente invention est de prévoir un filtre de boucle de correction de rotation permettant de réduire considérablement le temps de verrouillage d'un démodulateur QPSK ou QAM numérique.

Cet objet est atteint grâce à un filtre numérique pour une boucle à verrouillage de phase recevant au moins un signal d'entrée caractérisé par une période prédéterminée, comprenant un élément d'accumulation de valeurs de fréquence recevant la sortie d'un détecteur de phase ; et un élément d'accumulation de valeurs de phase recevant une somme pondérée de la sortie du détecteur de phase et du contenu de l'élément d'accumulation de valeurs de fréquence. Chacun desdits éléments d'accumulation comprend plusieurs emplacements de mémorisation de valeurs de fréquence ou de phase, des moyens étant prévus pour rendre opérants successivement les emplacements de mémorisation dans la boucle à verrouillage de phase pendant une période caractérisant le signal d'entrée.

Selon un mode de réalisation de la présente invention, les emplacements de l'élément d'accumulation de valeurs de fréquence sont accessibles pour être initialisés à des valeurs différentes.

Selon un mode de réalisation de la présente invention, le filtre comprend un compteur programmable cadencé au voisinage de la fréquence maximale admise par la technologie de fabrication du filtre, et dont le contenu sélectionne un emplacement correspondant de chacun des éléments d'accumulation afin de le rendre opérant dans la boucle à verrouillage de phase.

Selon un mode de réalisation de la présente invention, la boucle à verrouillage de phase est une boucle de correction de rotation pour un démodulateur d'un couple de signaux binaires modulés en quadrature de phase, la période prédéterminée étant la durée de transmission d'un bit par les signaux binaires.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1, précédemment décrite, représente une constellation des valeurs possibles d'un couple de signaux modulés en QPSK ;
la figure 2 représente schématiquement un circuit de correction de rotation classique d'un démodulateur QPSK ou QAM ; et
la figure 3 représente schématiquement un mode de réalisation de circuit de correction de rotation selon la présente invention.

Une solution que l'on pourrait envisager pour diminuer le temps de verrouillage serait d'utiliser plusieurs circuits de correction de rotation en parallèle, le registre de valeur de fréquence 22 de chacun des circuits de correction étant initialisé à une fréquence différente. On diminuerait alors le temps de verrouillage par un facteur égal au nombre de circuits de correction travaillant en parallèle. Bien entendu, la surface occupée augmenterait proportionnellement à ce nombre.

La présente invention propose de conduire en parallèle plusieurs essais de fréquence de porteuse en utilisant un seul circuit de correction de rotation. Pour cela les essais sont concurrents et utilisent à tour de rôle le circuit de correction à une fréquence supérieure à la fréquence symbole. Plus spécifiquement, les essais sont conduits à une fréquence au moins égale à la fréquence symbole multipliée par le nombre d'essais concurrents. Etant donné que le circuit de correction de rotation peut fonctionner à une fréquence fixe au moins égale à la fréquence symbole la plus élevée, le nombre d'essais concurrents que l'on peut effectuer est d'autant plus grand que la fréquence symbole est faible, ce qui est justement le but recherché, puisque c'est aux faibles fréquences symbole que le temps de verrouillage est le plus long.

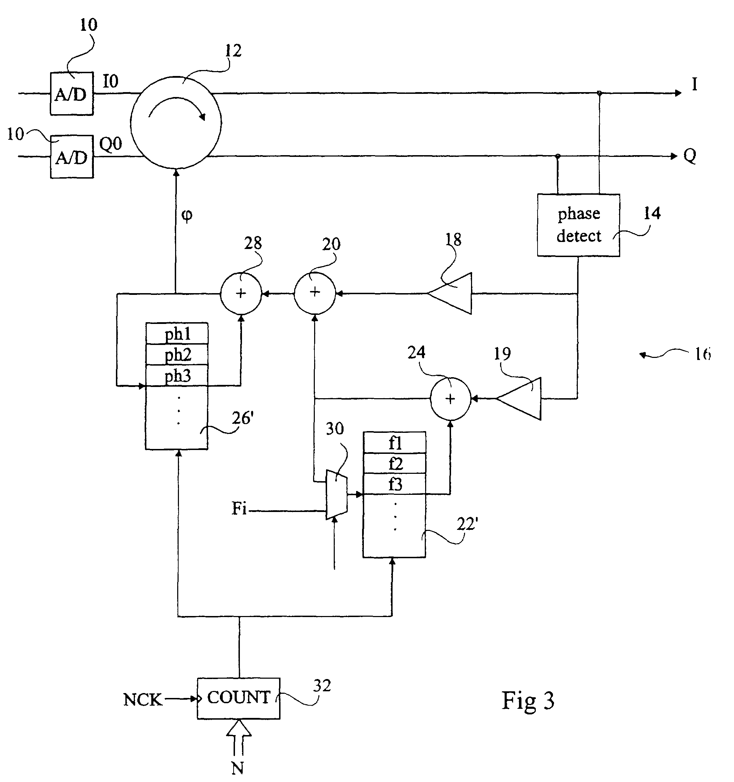

La figure 3 représente schématiquement un mode de réalisation de circuit de correction de rotation selon l'invention permettant ce fonctionnement. Des mêmes éléments qu'à la figure 2 sont désignés par des mêmes références. Le filtre de boucle numérique est ici désigné par 16'. Le registre de valeur de fréquence 22 et le registre de valeur de phase 26 de la figure 2 ont ici été remplacés respectivement par une mémoire à double accès 22' et une mémoire à double accès 26'.

Chacune de ces mémoires contient N emplacements de valeurs de fréquence ou de phase, où N est le nombre d'essais que l'on veut conduire en parallèle de manière concurrente. Le nombre N est choisi tel que le produit de la fréquence symbole par N soit inférieur à la fréquence maximale permise par la technologie du circuit, de sorte que l'on puisse accéder aux N emplacements mémoire en moins d'une période symbole.

Les mémoires à double accès 22' et 26' sont commandées à la fréquence maximale de manière à mettre successivement chaque emplacement mémoire dans la boucle pour qu'il remplisse le rôle d'un registre 22 ou 26 de la figure 2, c'est-à-dire pour qu'il soit accessible en même temps en lecture et en écriture.

Comme cela est représenté, les adresses de lecture/écriture des mémoires 22' et 26' peuvent être fournies par un compteur 32 que l'on programme pour compter jusqu'à N. Ce compteur est cadencé par une horloge NCK de fréquence au moins N fois supérieure à la fréquence symbole (horloge CK).

Les emplacements de la mémoire 26' peuvent contenir des valeurs initiales quelconques. Par contre, les emplacements de la mémoire 22' sont initialisés à des valeurs de fréquence différentes correspondant aux différentes plages de capture que l'on souhaite essayer. Pour cela, l'entrée de la mémoire 22' est précédée d'un multiplexeur 30 qui, pendant les essais successifs, sélectionne la sortie de l'additionneur 24 et qui, lors d'une phase d'initialisation, sélectionne une entrée Fi sur laquelle sont fournies en série des valeurs d'initialisation.

En fonctionnement normal, à l'apparition d'un front actif du signal d'horloge CK, un nouveau symbole est fourni par les convertisseurs analogique-numérique 10 et le compteur 32 est remis à zéro. Ce compteur 32 sélectionne les premiers emplacements des mémoires 22' et 26'. Ces emplacements sont alors mis à jour en fonction de la valeur produite par le détecteur de phase 14 pour le symbole courant.

Avant la survenue du symbole suivant, le compteur 32 est incrémenté successivement par l'horloge NCK jusqu'à la valeur N-1. A chaque incrément, un nouvel emplacement des mémoires 22' et 26' est sélectionné et mis à jour en fonction de la valeur fournie par le détecteur de phase 14, qui ne change pas pendant toute la durée du symbole courant.

Cette procédure est répétée pour chaque symbole reçu, c'est-à-dire à chaque période de l'horloge CK, jusqu'à ce que l'on ait reçu le nombre de symboles nécessaire à une convergence.

Alors, si l'emplacement sélectionné de la mémoire 22' contient une valeur correspondant à la fréquence de porteuse, un détecteur de verrouillage classique, non représenté, active un signal d'indication de verrouillage. Ce signal de verrouillage provoque l'arrêt du compteur 32 de manière que restent sélectionnés les emplacements des mémoires 22' et 26' correspondant à la fréquence de porteuse.

Si le signal de verrouillage n'est pas activé, cela signifie qu'aucune des valeurs de fréquence stockées dans la mémoire 22' n'était bonne. Dans ce cas, on réinitialise les emplacements de la mémoire 22' par une nouvelle série de valeurs de fréquence pour ensuite recommencer la procédure précédemment décrite.

Un exemple de détecteur de verrouillage classique comprend un accumulateur qui reçoit des valeurs 1 ou -1, selon que le détecteur de phase 14 indique un bon angle ou non. Lorsque le contenu de l'accumulateur dépasse un seuil, on indique un verrouillage. Afin d'utiliser un tel détecteur de verrouillage selon l'invention, son accumulateur a la même structure que l'accumulateur de phase (26', 28) de la figure 3, c'est-à-dire que le registre d'accumulation est remplacé par une mémoire à double accès commandée par le compteur 32.

Pour réinitialiser les emplacements de la mémoire 22', le multiplexeur 30 est commandé pour sélectionner l'entrée Fi. Les nouvelles valeurs de fréquence sont alors présentées en série sur l'entrée Fi à la cadence de l'horloge NCK tandis que le compteur 32 compte ses N cycles.

Bien entendu, cette phase de réinitialisation n'est pas nécessaire si le nombre N d'emplacements est suffisant pour couvrir la plage d'incertitude de la fréquence de porteuse.

En principe, le nombre N varie en fonction de la fréquence symbole. Les mémoires 22' et 26' ont un nombre d'emplacements fixe au moins égal à la valeur maximale de N. Si la valeur N utilisée est inférieure, les emplacements en excès des mémoires 22' et 26' ne sont pas sélectionnés par le compteur 32.

Les mémoires à double accès 22' et 26' peuvent être de structure simplifiée, puisqu'un même emplacement est sélectionné à la fois en lecture et en écriture. Par ailleurs, comme ces mémoires reçoivent les mêmes adresses, elles peuvent partager le même décodeur d'adresses.

Selon une variante, les mémoires 22' et 26' peuvent être remplacées par des colonnes de registres précédées d'un démultiplexeur et suivies d'un multiplexeur.

La présente invention a été décrite en relation avec un démodulateur QPSK ou QAM, mais elle s'applique à un filtre d'une boucle à verrouillage de phase quelconque nécessitant des essais de fréquence successifs pour retrouver une période caractérisant un signal d'entrée.

## Revendications

1. Filtre numérique pour une boucle à verrouillage de phase recevant au moins un signal d'entrée **caractérisé par** une période prédéterminée, comprenant :
- un élément d'accumulation (22) de valeurs de fréquence recevant la sortie d'un détecteur de phase (14) ; et
- un élément d'accumulation (26) de valeurs de phase recevant une somme pondérée de la sortie du détecteur de phase et du contenu de l'élément d'accumulation de valeurs de fréquence ;
**caractérisé en ce que** chacun desdits éléments d'accumulation comprend plusieurs registres (22', 26') qui sont connectés à tour de rôle pour servir d'accumulateur pendant une fraction d'une période caractérisant le signal d'entrée.

2. Filtre numérique selon la revendication 1, **caractérisé en ce que** les registres de l'élément d'accumulation de valeurs de fréquence (22') sont accessibles pour être initialisés à des valeurs différentes.

3. Filtre numérique selon la revendication 1, **caractérisé en ce qu'**il comprend un compteur programmable (32) cadencé au voisinage de la fréquence maximale (NCK) admise par la technologie de fabrication du filtre, et dont le contenu sélectionne un registre correspondant de chacun des éléments d'accumulation afin de le connecter pour servir d'accumulateur.

4. Filtre numérique selon l'une quelconque des revendications 1 à 3, **caractérisé en ce que** la boucle à verrouillage de phase est une boucle de correction de rotation pour un démodulateur d'un couple de signaux binaires (I, Q) modulés en quadrature de phase, la période prédéterminée étant la durée de transmission d'un bit par les signaux binaires.

## Patentansprüche

1. Digitales Filter für eine phasensynchronisierte bzw. phasenverriegelte Schleife, dem wenigstens ein durch eine vorbestimmte Frequenz gekennzeichnetes Eingangssignal zugeführt wird, wobei das Filter umfaßt:
- ein Akkumulatorelement (22) zur Akkumulierung von Frequenzwwerten, wobei dem Akkumulatorelement die Ausgangsgröße eines Phasendetektors zugeführt wird; sowie
- ein Akkumulatorelement (26) zur Akkumulierung von Phasenwerten, wobei dem Akkumulatorelement eine gewichtete Summe der Ausgangsgröße des Phasendetektors und des Inhalts des Frequenzwerte-Akkumulatorelemnts zugeführt wird; **dadurch gekennzeichnet, daß** jedes der Akkumulatorelemente jeweils mehrere Register (22', 26') umfaßt, die so geschaltet sind, daß sie aufeinanderfolgend als Akkumulator während eines Bruchteils einer das Eingangssignal kennzeichnenden Periode dienen.

2. Digitales Filter nach Anspruch 1, **dadurch gekennzeichnet, daß** die Register des Frequenzwerte-Akkumulators (22') zur Initialisierung mit unterschiedlichen Werten zugänglich sind.

3. Digitales Filter nach Anspruch 1, **dadurch gekennzeichnet, daß** es einen programmierbaren Zähler (32) aufweist, der benachbart der nach der Herstellungstechnologie zulässigen maximalen Frequenz (NCK) getaktet wird, und dessen Inhalt ein entsprechendes Register jedes der Akkumulatorelemente auswählt, zur Schaltung um als Akkumulator zu dienen.

4. Digitales Filter nach einem der Ansprüche 1 bis 3, **dadurch gekennzeichnet, daß** die Phasenverriegelungs- bzw. -synchronisierschleife eine Schleife zur Rotationskorrektur für einen Demodulator zur Demodulation eines Paars von in Phasenquadratur modulierten Binärsignalen (I, Q) ist, wobei die vorgegebene Periode die Dauer der Übertragung eines Bits durch die Binärsignale ist.

## Claims

1. A digital filter for a phase-locked loop receiving at least one input signal **characterized by** a predetermined period, including:
- a frequency value accumulation element (22) receiving the output of a phase detector (14); and
- a phase value accumulation element (26) receiving a weighted sum of the output of the phase detector and of the content of the frequency value accumulation element;
**characterized in that** each of the accumulation elements includes several registers (22', 26') successively connected to be used as an accumulator during a fraction of one period characterizing the input signal.

2. The digital filter of claim 1, **characterized in that** the registers of the frequency value accumulation element (22') are accessible to be set to different values.

3. The digital filter of claim 1, **characterized in that** it includes a programmable counter (32) rated in the vicinity of the maximum frequency (NCK) admitted by the filter's manufacturing technology, the content of which selects a corresponding register of each of the accumulation elements to be connected to be used as an accumulator.

4. The digital filter of any of claims 1 to 3, **characterized in that** the phase-locked loop is a rotation correction loop for a demodulator of a pair of binary signals (I, Q) modulated in phase quadrature, the predetermined period being the transmission duration of a bit by the binary signals.
